Europäisches Patentamt

(19) European Patent Office

Office européen des brevets

(11) Publication number: **0 276 962**
**A1**

## (12) EUROPEAN PATENT APPLICATION

(21) Application number: 88300575.3

(22) Date of filing: 25.01.88

(51) Int. Cl.4: **C 23 C 14/34**

(30) Priority: 27.01.87 US 7743

(43) Date of publication of application:
03.08.88 Bulletin 88/31

(84) Designated Contracting States:
AT BE CH DE FR GB IT LI LU NL SE

(71) Applicant: MACHINE TECHNOLOGY INC.
25 Eastmans Road
Parsippany New Jersey 07054 (US)

(72) Inventor: Hillman, Gary
15 Goodhart Drive
Livingston New Jersey 07039 (US)

(74) Representative: Beresford, Keith Denis Lewis et al
BERESFORD & Co. 2-5 Warwick Court High Holborn
London WC1R 5DJ (GB)

(54) Cooling device for a sputter target and source.

(57) An assembly (30) for use in a deposition apparatus includes a source of material (35) to be deposited having a surface and an electrode (31) having a surface disposed adjacent the surface of the source, the assembly is characterized by coupling means (37, 50', 80) disposed between the electrode and the source and extending within one of the surfaces for increasing the thermal coupling between the electrode and the source.

EP 0 276 962 A1

## Description

The present invention relates generally to a vacuum deposition apparatus for coating substrates with a variety of film compositions, and more particularly, to a cooling device for a sputter target and source, i.e., cathode and target electrode assembly having enhanced cooling capability and sputtering characteristics.

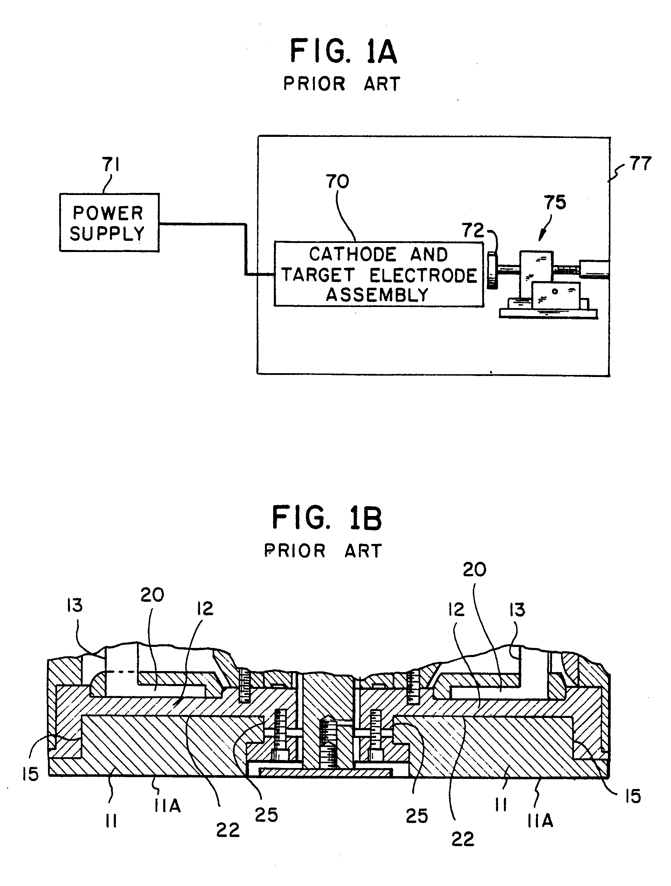

Referring to Figure 1A, a deposition apparatus in accordance with the prior art for depositing a thin film layer to a surface of a workpiece, such as a semiconductor wafer is depicted. The apparatus is constructed of a combined cathode and target electrode assembly, including a cooling mechanism (not shown), which are generally designated by reference numeral 70. A power supply 71 is coupled to the assembly 70 for applying a high voltage thereto. A workpiece 72, such as a semiconductor wafer having a generally circular configuration, is placed on a mounting mechanism generally designated by reference numeral 75, which may rotate the workpiece 72 relative to the assembly 70. When voltage is applied to the assembly 70, deposition of a thin film layer from the target electrode occurs on the exposed surface of the workpiece 72. A housing 77, wherein a vacuum is maintained, contains the assembly 70, the workpiece 72, and the mounting mechanism 75.

Referring to Figure 1B, a portion of the cathode and target electrode assembly of the prior art is depicted in detail. A circular target electrode 11, as a source of material to be sputtered, is disposed adjacent a circular cathode 12. For assembly purposes, a slight gap exists between the cathode 12 and the target electrode 11 at a planar surface 22 of the target electrode, when the target electrode is cool. Pipes 13 are utilized to convey water or other cooling fluid to a chamber 20 provided adjacent the surface of the cathode 12, for cooling the cathode and primarily the target electrode 11. During the sputtering process, heat is generated at a surface 11A of the target electrode 11. In response, the target electrode 11 expands radially outward, pressing against a surface 15 of the cathode 12. Accordingly, cooling of the target electrode 11 by the water in the chamber 20 is effected primarily through the surface 15 of the cathode 12. Owing to the radial expansion of the target electrode 11 upon heating, the fit of the target electrode 11 and the cathode 12 at the surface 22 of the target electrode remains relatively loose, providing inefficient cooling of the target electrode 11 thereat.

Further, with radial expansion of the target electrode 11, contact of the target electrode 11 and the cathode 12 is reduced at a surface 25 of the cathode 12, limiting cooling therethrough. Thus, cooling of the target electrode 11 is afforded primarily via the surface 15 of the cathode 12. With heating occurring at the surface 11A of the target electrode 11, significant temperature differentials occur throughout the target material, across the gap at the surface 22 to the water cooled cathode 12, and through the cathode 12 itself.

At a power flux of about 160W/cm$^2$ typically flowing across the surface 15 of the cathode 12, a temperature differential of approximately 100°C can exist. Owing to the length of the path through the cathode 12 from the surface 15 to the chamber 20, an additional drop of about 80°C can also exist. Assuming a reasonable flow and temperature or the cooling water inlet via the pipes 13, the coolest portion of the target electrode 11 at the surface 15 of the cathode 12 is generally at a temperature or at least 230°C. From the surface 15 of the cathode 12 to the surface 11A of the target electrode 11 there can be a temperature rise in the case of aluminum alloys of an additional 250°C, which is approximately the melting point of some eutectics which may be present in the target material. The generation of such high temperatures in the target electrode 11, particularly at the surface 11A, results in an unacceptable lack of control of the deposition process which can produce a runaway voltage at high power.

One known cathode and target electrode assembly which overcomes the above mentioned cooling problem incorporates a target electrode which is soldered directly within the hollow of the cathode to provide a unitary construction. This assembly, however, suffers from a number of notable drawbacks which results from this construction. The most significant one is the inability of this assembly to permit replacement of the target electrode in a simple and economical manner. For example, it is required that all remanents of the target electrode be completely machined from within the cathode hollow prior to soldering a replacement target electrode. Accordingly, there is a need for a simple, efficacious means of cooling the target electrode 11 of such a deposition apparatus.

In accordance with the present invention, there is provided an assembly for use in a deposition apparatus including a source of material to be deposited having a surface, and an electrode having a surface disposed adjacent the surface of the source, the assembly characterized by coupling means disposed between the electrode and the source and extending within one of the surfaces for increasing the thermal coupling therebetween.

In accordance with the present invention, the coupling means is constructed of an annular member or a plurality of concentric annular members disposed between the cathode and the target electrode. The annular member comprises an insert having a base and a portion projecting from the base. The base is disposed in an annular recess in the target electrode or cathode, and the portion projecting from the base is disposed in a corresponding annular recess in the cathode or target electrode. Preferably, the annular member comprises copper, and the clearance between the annular member and the recess is between 0.0076 and 0.013 centimeters when the electrode is cool.

More preferably, the projecting portion is integrally formed with the cathode or target electrode so as to eliminate the aforementioned base and the insert nature of the annular member. In another embodiment of the present invention, the heat-dissipating member disposed between the cathode and the target electrode comprises segments of an annulus.

Upon heating of the target electrode, the electrode expands radially outward, pressing against each of the annular members. In this fashion, each of the annular members dissipate heat engendered in the electrode. The annular members may be positioned according to the heat distribution in the target electrode. Further, the dimensions of the base and the portion projecting from the base of each annular member may be adjusted to accommodate the heat accumulation at a particular location.

Generally, the present invention entails the use of a member disposed between and in contact with the cathode and the target electrode so as to dissipate additional heat from the target electrode. That is, the member increases thermal coupling of the cathode and the target electrode. The member may be formed as an insert or integrally formed within the cathode or target electrode. Preferably, the member is disposed proximate to the cooling water so as to enhance the efficiency of its heat dissipation. Further, the member is configured such that upon expansion of the target electrode owing to heating thereof, the target electrode presses against the member. Any number of members may be utilized in accordance with the heat distribution of the target electrode. The configuration of each member may be altered to accommodate the heat accumulation at a particular point. For example, a member having a larger surface projecting into the target electrode may be employed at a point on the electrode having a high temperature.

The present invention entails several advantages. The target electrode may be more efficiently cooled by positioning the heat-dissipating members proximate to the flow of cooling water. In the prior art, the side wall of the cathode, which is responsible for most of the heat conduction, is located relatively remote from the flow of cooling water. Thus, the present invention permits further exploitation of the cooling water, resulting in greater cooling efficiency. Unlike the prior art, the present invention permits selective positioning and modification of the heat-dissipating members to accommodate the distribution of heat in the target electrode. Different points of the target electrode exhibit different temperatures. The members may be positioned at concentrations of heat, and the dimensions of these members may be adjusted to accommodate such concentrations. As such, temperature differentials at all points in the target may be reduced, extending the life of the target electrode. The present invention permits material to be utilized for a target electrode which exhibits sensitivity to temperature differentials; since, such differentials are efficiently reduced via the heat-dissipating members of the present invention.

In order that the present invention may be more fully understood, it will now be described with reference to the accompanying drawings in which:

FIG. 1A is a schematic diagram of a deposition apparatus according to the prior art.

FIG. 1B is a fragmentary, sectional view of a portion of a cathode and target electrode assembly of the deposition apparatus of FIG. 1A.

FIG. 2 is an exploded, sectional view of a cathode and target electrode assembly in accordance with one embodiment of the present invention.

FIG. 3 is a bottom plan view of the cathode portion of the assembly depicted in FIG 2.

FIG. 4 is an exploded, sectional view of a cathode and target electrode assembly in accordance with another embodiment of the present invention.

FIG. 5 is a bottom plan view of the cathode portion of the assembly depicted in FIG. 4.

FIG. 6 is a bottom plan view of a cathode portion of an assembly in accordance with another embodiment of the present invention.

FIG. 7 is a sectional view of a cathode in accordance with another embodiment of the present invention.

FIG. 8 is a sectional view of a target electrode in accordance with another embodiment of the present invention.

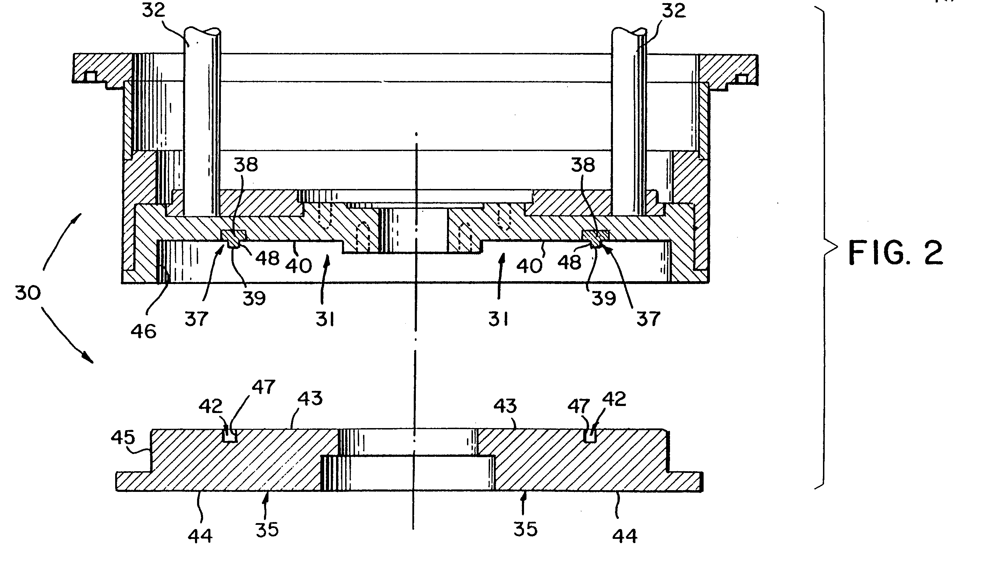

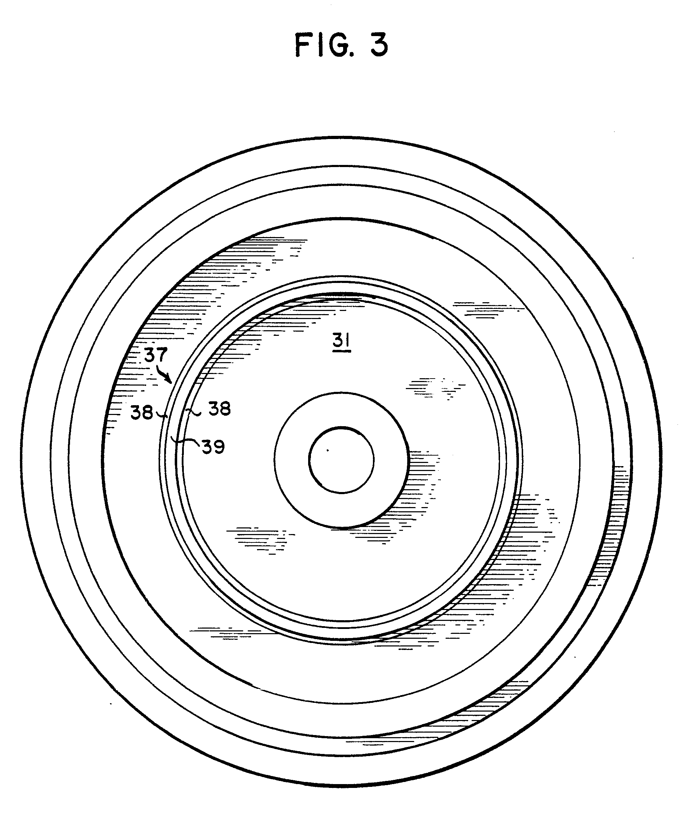

The present invention entails a cooling device for the target electrode of a deposition apparatus. Referring to FIGS. 2 and 3, an assembly generally designated by reference numeral 30 includes a circular cathode 31 having a hollow, and pipes 32 utilized to conduct water to the surface of the cathode 31 for cooling purposes. A circular target electrode 35, which in accordance with one application comprises aluminum to be deposited in a thin film layer, is shown separated from the cathode 31. In operation, the target electrode 35 is inserted into the hollow of the cathode 31 and in contact therewith, as depicted in FIG. 1B. An annular member 37 having a base 38 and a projecting portion or member 39 extending perpendicularly from the base 38 is disposed in an annular recess provided in a surface 40 of the cathode 31. Preferably, the annular member 37 comprises copper or other such material having good thermal conductivity. An annular recess 42 is disposed in a surface 43 of the target electrode 35. The recess 42 is adapted to engage the portion 39 of the annular member 37. Preferably there is a radial clearance between the target electrode 35 and the portion 39 of the member 37 of approximately 0.0076 to 0.013 centimeters, when the electrode 35 is cool. With the target electrode 35 and the cathode 31 assembled as in FIG. 1B, the annular member 37 projects from the surface 40 of the cathode 31 into the annular recess 42 of the electrode 35.

In operation, when the surface 44 of the target electrode 35 is heated, the target electrode 35 expands radially outward, pressing a surface 45 against a surface 46 of the cathode 31, and a surface 47 of the annular recess 42 against a surface 48 of the projecting portion 39 of the annular member 37. In this fashion, the annular member 37 provides additional cooling of the target electrode 35, particularly through the additional contact surface 48 of the annular member 37. The annular member 37 may be disposed proximate the cooling water provided by the pipes 32, to enhance the cooling effect upon the target electrode 35 by minimizing the path therebetween. The annular member 37 may be disposed considerably more closely to the cooling water provided by the pipes 32 than the surface 46 of the cathode 31. Accordingly, the annular member 37 provides a more efficient means of cooling the target electrode 35 than the surface 46 of the cathode 31. Further, the dimensions of the annular member 37 may be varied to suit the needs of the occasion. Specifically, the base 38 of the member 37, or the surface 48 of the annular member 37 may be enlarged to increase the capacity of the annular member 37 to drain heat from the target electrode 35.

Further, it is generally an operating condition that the power flux varies across the eroding surface 44 of the electrode 35. Accordingly, the annular member 37 may be positioned at a point of maximum power flux to prevent an excessive accumulation of heat threat.

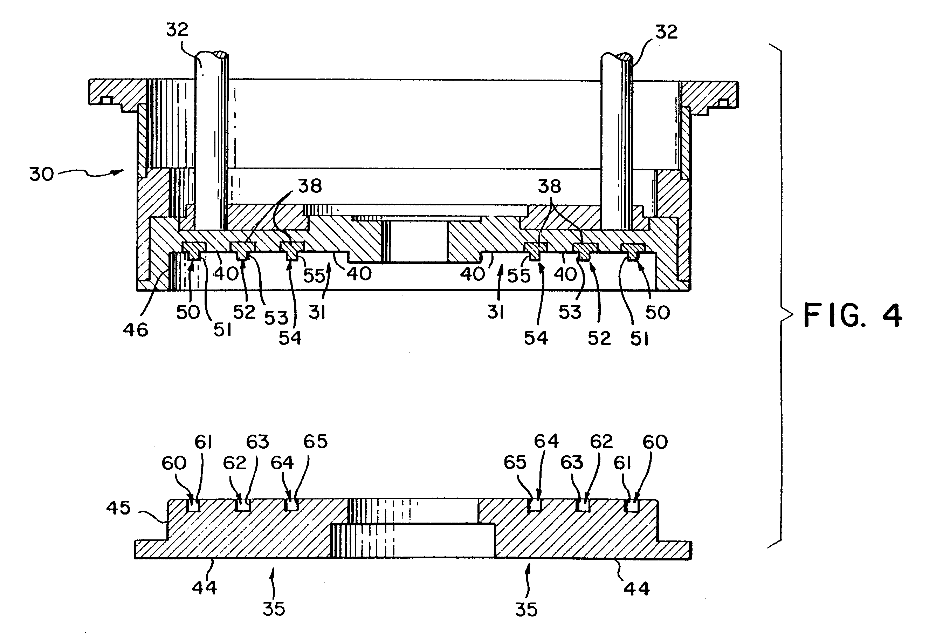

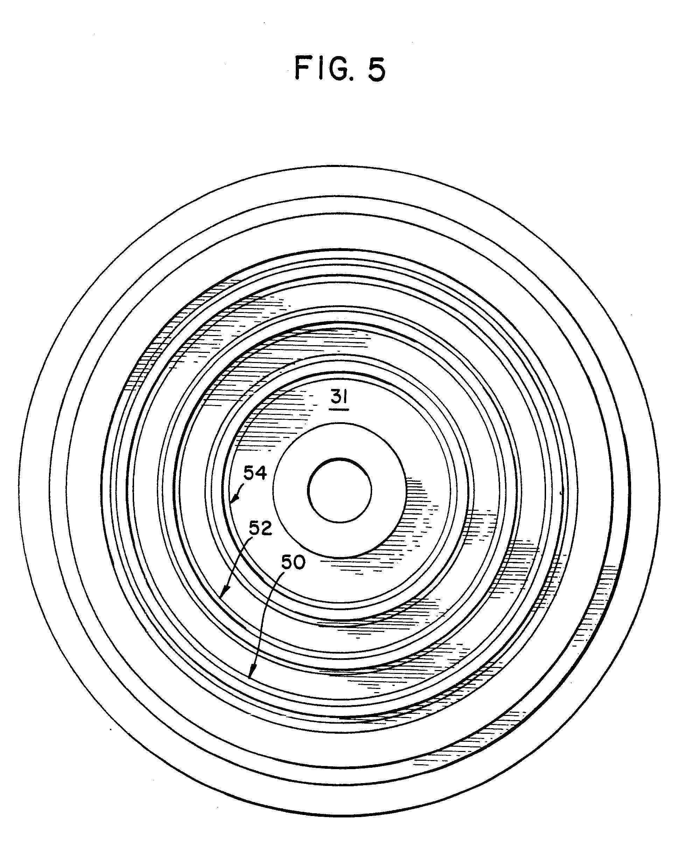

Referring to FIGS. 4 and 5, a second embodiment of the present invention is depicted entailing annular members 50, 52, and 54 which are similar to annular member 37 of FIG.s 2 and 3. The bases of the annular members 50, 52, and 54 are disposed, respectively, in annular recesses provided in the surface 40 of the cathode 31. A portion of each of the annular members 50, 52, and 54 projects from the base thereof. Annular recesses 60, 62, and 64 in the target electrode 35 are adapted to receive, respectively, the projecting portions of the annular members 50, 52, and 54. Preferably, the annular members 50, 52, and 54 comprise copper as previously noted.

In operation, the target electrode 35 is inserted into the hollow of the cathode 31 with the annular members 50, 52, and 54 disposed in, respectively, the annular recesses 60, 62, and 64 of the target electrode 35. As the temperature of the surface 44 of the target electrode 35 rises, the target electrode 35 expands radially outward. As a result, a surface 61 of the annular recess 60 presses against a surface 51 of the annular member 50. Similarly, a surface 63 of the annular recess 62 presses against a surface 53 of the annular member 52; and, a surface 65 of the annular recess 64 presses against a surface 55 of the annular member 54. In this fashion, the cooling of the target electrode 35 is enhanced via contact of the target electrode 35 with the additional cooling surfaces of the annular members 50, 52, and 54. Since the annular members 50, 52, and 54 are disposed more closely than the surface 46 of the cathode 31 to the cooling water provided by the pipes 32, the cooling effect afforded by the annular members 50, 52, and 54 is more efficient in nature.

As the power flux can vary across the eroding surface 44 of the target electrode 35, there is engendered a nonuniform temperature distribution thereon. Accordingly, the annular members 50, 52, and 54 may be placed at positions of highest heat concentration, to most effectively dissipate it. Further, the dimensions of the base and portion extending therefrom of each of the annular members may be adjusted to suit a particular cooling situation. For example, the areas of the surfaces 51, 53, and 55 of, respectively, the annular members 50, 52, and 54 may be independently varied to accommodate temperatures occurring in particular positions. Preferably, the radial clearance between the projecting portions of the annular members 50, 52, and 54, and, respectively, the annular recesses 60, 62, and 64 is in the range 0.003 to 0.005 inches, when the target electrode 35 is cool.

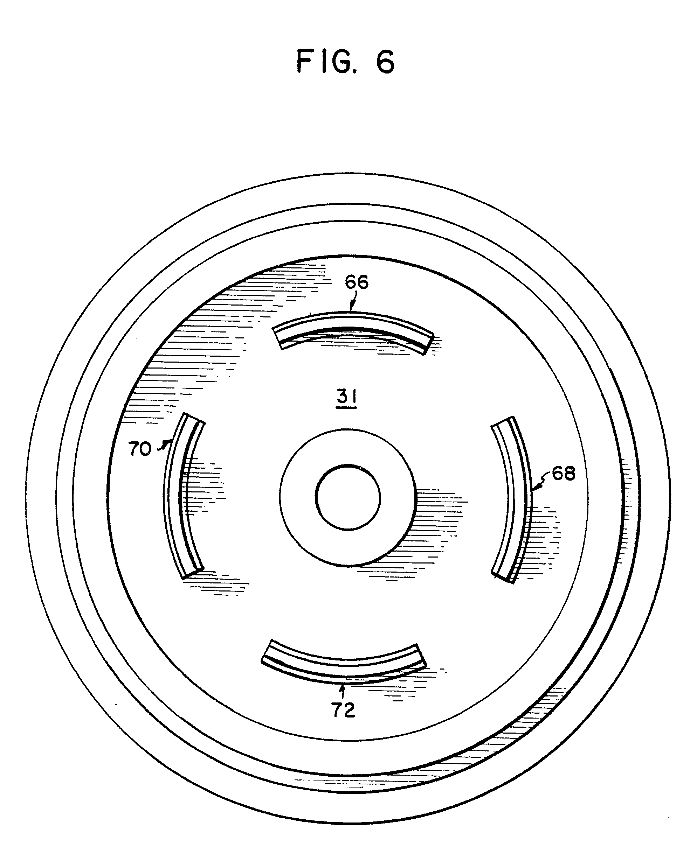

Referring to FIG. 6, a third embodiment of the present invention is depicted. This embodiment is similar to that of FIGS. 2 and 3 except that the member disposed in the cathode 31 comprises annular segments 66, 68, 70 and 72, rather than the continuous annular member 37 of FIG. 3. Accordingly, the recess in the target electrode 35 for receiving the annular segments 66, 68, 70 and 72 entails corresponding recesses shaped as annular segments. The operation of this embodiment is similar to that described above for the first embodiment.

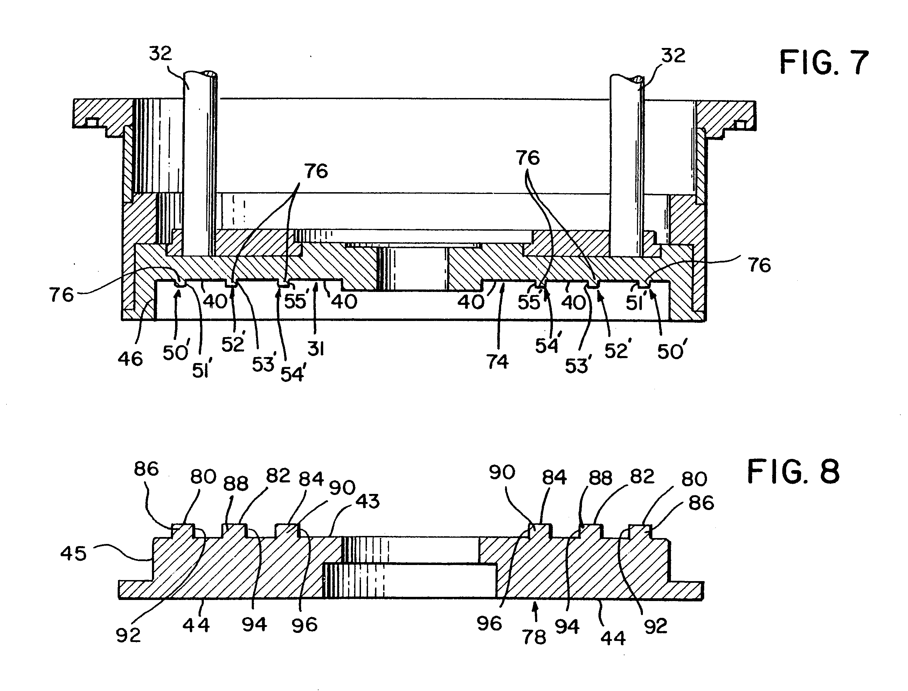

Referring now to FIG. 7, there is disclosed a cathode 74 constructed in accordance with the preferred embodiment of the present invention. The annular members 50', 52', and 54' are each integrally formed from the cathode 74, as opposed to being an insert as previously described with respect to the embodiment of, for example, FIGS. 2 and 4. In this embodiment, the annular members 50', 52', and 54' each include a projecting portion or member 76 extending from surface 40 and having inner radial surfaces 51', 53', and 55'. The annular members 50', 52', and 54' although shown as having a rectangular cross-section, may be of other shapes, for example, triangular, trapezoidal, and the like. The operation of this embodiment is similar to that described above.

Referring now to FIG. 8, there is disclosed a target electrode 78 in accordance with still another embodiment of the present invention. In accordance with this embodiment, annular members 80, 82, and 84 are of the type described with respect to FIG. 7 by being integrally formed from the target electrode 78, each including a respective projecting portion or member 86, 88, and 90. Each of the projecting portions 86, 88, and 90 include a respective inwardly facing radial surface 92, 94, and 96. The target electrode 78 is mated within the hollow of a cathode (not shown) having corresponding annular recesses of the type as previously described. The operation of this embodiment is similar to that as described above.

The particular configuration, and positioning relative to the cathode and target electrode of the heat-reducing members described above may be varied to suit the needs of the occasion. The members need not be T-shaped or annular. For purposes of the present invention, it is sufficient that these members provide additional contact area with the target electrode, particularly at a location proximate to the cooling water, to efficiently dissipate heat. The present invention is designed to enhance the thermal coupling of the water-cooled cathode and the heated target electrode. Further, for purposes of the present invention it is preferable that these heat-reducing members be situated such that upon heating of the target electrode the electrode expands against these members. However, as indicated above, the particular configuration and placement of these members may be varied widely in accordance with these general principles of the present invention.

## Claims

1. An assembly for use in a deposition apparatus including a source of material to be deposited having a surface and an electrode having a surface disposed adjacent the surface of said source, said assembly characterized by coupling means (37, 66, 50', 80) disposed between said electrode and said source and extending within one of said surfaces for increasing the thermal coupling between said electrode and said source.

2. The assembly of Claim 1, characterized in that said coupling means (80) includes a member (86) projecting from said source, said electrode having a recessed region facing said source for receiving said member, said member and said recessed region being configured so that said member expands against said electrode upon heating of said source.

3. The assembly of Claim 1, characterized in that said coupling means (37, 66, 50') includes a member (39, 76) projecting from said electrode, said source having a recessed region (42) facing said electrode for receiving said member, said member and said recessed region being configured so that said source expands against said member upon heating of said source.

4. The assembly of Claim 2 or 3, characterized in that said coupling means (37, 66, 50', 80) includes an annular member (39, 76, 86) and said recessed region (42) comprises a first annular recess (42).

5. The assembly of Claim 4, characterized in that said annular member (39) includes a base (38), said annular member being disposed substantially perpendicularly to said base.

6. The assembly of Claim 5, characterized in that said electrode includes a second annular recess facing said first annular recess (42), said base (38) being disposed in said second annular recess and said annular member (39) being disposed in said first annular recess (42).

7. The assembly of Claim 2 or 3, characterized in that said coupling means (37, 66, 50', 80) includes a plurality of annular members (50, 76, 86) concentrically arranged, and said recessed region (42) includes a corresponding first plurality of annular recesses (42) each having one of said plurality of annular members disposed therein.

8. The assembly of Claim 2 or 3, characterized in that said coupling means (66) comprises a segment of an annular member (66, 68, 70, 72), and said recessed region (42) comprises a recess (42) configured as a corresponding segment of an annulus.

9. The assembly of Claim 7 or 8, characterized in that said plurality of annular members (50, 66, 68, 70, 72, 76, 86) are individually disposed within said source at preselected regions corresponding to locations of preselected values of power flux.

10. The assembly according to any one of the preceeding claims, characterized in that said source comprises a target electrode (35) and said electrode comprises a cathode (31).

11. The assembly according to any one of the preceding claims, further characterized by means (71) coupled to said source for removal of material to be deposited, mounting means (75) for mounting a workpiece for receiving a layer of said material, and a housing (77) for receiving said source, said electrode, said coupling means, and said mounting means.

12. The assembly of Claim 1, characterized in that said source includes a first planar surface portion (43), said electrode includes a second planar surface portion (40) disposed against said first planar surface portion, and said coupling means (37, 66, 50', 80) includes a member (39, 76, 86) of rectangular cross-section projecting away from one of said surface portions.

13. The assembly of Claim 12, further characterized by a recess (42) of corresponding rectangular cross-section extending within another of said surface portions (40, 43) for releasably receiving said member (39, 76, 86) so as to maintain said first and second planar surface portions (40, 43) disposed against each other.

14. The assembly of Claim 13, characterized by said member (39, 76, 86) having an upstanding wall surface (48, 51', 92) arranged transverse to said first and second planar surface portions (40, 43), said recess (42) defined by at least one recessed wall surface (47, 61) arranged transverse to said first and second planar surface portions, whereby the radial expansion of said source causing engagement of said upstanding wall surface of said member with said recessed wall surface of said recess for increasing the thermal coupling between said source and said electrode.

15. The assembly of Claim 14, characterized by the radial expansion of said source causing engagement of said upstanding wall surface (48, 51', 92) of said member (39, 76, 86) with said recessed wall surface (47, 61) of said recess (42) from a location adjacent said first and second planar surface portions (40, 43) to the free end of said member for increasing the thermal coupling between said source and said electrode.

16. The assembly according to any one of the preceeding claims, characterized in that said coupling means (37, 66, 50′, 80) is arranged at a preselected region corresponding to a location of a preselected value of power flux.

0276962

# FIG. 1A
PRIOR ART

71

POWER SUPPLY

70

CATHODE AND TARGET ELECTRODE ASSEMBLY

72

75

77

# FIG. 1B
PRIOR ART

FIG. 2

0276962

# FIG. 3

FIG. 4

0276962

FIG. 5

0276962

# FIG. 6

FIG. 7

FIG. 8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PATENT ABSTRACTS OF JAPAN, vol. 2, no. 81, 28th June 1978, page 1056 C 78; & JP-A-53 37 588 (TOKYO SHIBAURA DENKI K.K.) 06-04-1978 * Whole document * | 1,2,4,5,10,12-15 | C 23 C 14/34 |
| X | PATENT ABSTRACTS OF JAPAN, vol. 9, no. 36 (C-266)[1759], 15th February 1985; & JP-A-59 179 784 (FUJITSU K.K.) 12-10-1984 * Whole document * | 1,2,4,5,10,12-15 | |
| A | GB-A-2 161 837 (BALZERS AG) | | |
| A | GB-A-2 173 217 (BALZERS AG) | | |

TECHNICAL FIELDS
SEARCHED (Int. Cl.4)

C 23 C
H 01 J

The present search report has been drawn up for all claims

| Place of search | Date of completion of the search | Examiner |
|---|---|---|
| THE HAGUE | 20-04-1988 | PATTERSON A.M. |

EPO FORM 1503 03.82 (P0401)